# FASCICULE DE BREVET EUROPEEN

(11) **EP 3 483 790 B1**
(45) Date de publication et mention de la délivrance du brevet: **23.03.2022**
(21) Numéro de dépôt: 18205214.2
(22) Date de dépôt: 08.11.2018
(51) Int. Cl.: G06K 19/07, G06K 19/077

(54) **DISPOSITIF DE SÉCURITÉ TEL QU'UNE CARTE À PUCE**
SICHERHEITSVORRICHTUNG, BEISPIELSWEISE EINE CHIP-KARTE
SECURITY DEVICE SUCH AS A SMART CARD

(30) Priorité: 08.11.2017 FR 1760508
(43) Date de publication de la demande: 15.05.2019
(73) Titulaire: IDEMIA France, 92400 Courbevoie (FR)
(72) Inventeur: BOSQUET, Olivier, 92400 COURBEVOIE (FR); AMIOT, Lucien, 92400 COURBEVOIE (FR); LENCOU, Philippe, 92400 COURBEVOIE (FR)

(56) Documents cités:
- FR-A1- 3 029 530
- US-A1- 2009 200 650
- US-A1- 2012 255 763
- US-B1- 6 798 049

## Description

La présente invention concerne un dispositif de sécurité tel qu'une carte à puce, par exemple de type bancaire ou document d'identité.

Une carte à puce comporte un corps ou support de carte et au moins un circuit électronique. Le circuit électronique est par exemple un circuit intégré dédié au paiement sécurisé ou au stockage des données d'identité.

Pour la communication du circuit intégré avec l'extérieur, elle comporte une interface de contact et/ou un moyen de communication sans contact, tel qu'une antenne reliée électriquement au circuit intégré.

Ainsi, le circuit intégré peut communiquer avec l'extérieur à travers l'interface de contact mise au contact d'un dispositif adapté pour cette communication, ce type de communication étant connu comme communication par contact (par exemple telle que définie par la norme ISO 7816-2), ou à travers l'antenne, cette communication étant connue comme communication sans contact (par exemple selon les normes ISO 14443 ou NFC/ISO 15693). Le corps de carte définit le format de la carte à puce et est souvent formé par plusieurs couches, substrats ou inlays disposés entre deux couches plastiques qui forment respectivement des faces externes du corps.

Des couches sont utilisées afin d'intégrer dans le corps de carte des composants électroniques constituant des interfaces supplémentaires avec l'extérieur et nommés ci-dessous composants électroniques d'interface.

Des cavités sont réalisées dans les couches afin d'y placer des composants électroniques.

On connait des cartes à puce dans lesquelles l'interface de contact débouche sur une face externe du corps de carte, et au moins un composant électronique, tel qu'un afficheur, un lecteur d'empreinte, un bouton, un capteur de lumière, une diode électroluminescente (connu en nomenclature anglo-saxonne comme « *Light-emitting diode* » ou Led), un buzzer, un composant de communication bluetooth ou autre, constitue une interface supplémentaire avec l'extérieur. Ces interfaces supplémentaires, peuvent affleurer ou ne pas affleurer la face externe du corps de carte selon des modèles de carte à puce.

Dans un type connu de carte à puce, un module formé par l'interface de contact et le circuit intégré monté sur une face interne de l'interface de contact, est situé dans une cavité d'interface réalisée dans le corps de carte, l'interface de contact affleurant la face externe du corps de carte, c'est-à-dire étant au même niveau que la face externe du corps.

On connait des cartes à puce dans lesquelles le composant électronique d'interface (autre que l'interface de contact de la carte à puce) est monté sur un circuit imprimé de type circuit imprimé flexible (connu en nomenclature anglo-saxonne comme « *Flexible Printed Circuit* » ou FPC). Ce circuit imprimé comporte notamment des moyens de contrôle, tels qu'un microcontrôleur gérant le fonctionnement du composant électronique d'interface, des moyens de stockage d'énergie, et un moyen additionnel de communication avec l'extérieur, tel qu'une antenne.

Le circuit imprimé flexible constitue dans ce type de carte à puce une couche, substrat ou inlay.

Les cartes à puce actuelles comportent en général une antenne permettant la communication sans contact du circuit intégré avec l'extérieur. L'antenne est réalisée sur une couche, substrat ou inlay, différent de la couche constituée par le circuit imprimé et nommé ci-dessous inlay d'antenne. L'antenne est reliée au circuit intégré de sorte que le circuit intégré puisse communiquer avec l'extérieur à travers l'antenne.

Une fois qu'une carte à puce est fabriquée, elle doit être personnalisée. Les opérations de personnalisation sont distinctes pour le circuit intégré et pour le composant électronique d'interface.

Dans le type de cartes à puce décrites ci-dessus, le circuit intégré peut être personnalisé par contact à travers l'interface de contact, ou sans contact à travers l'inlay d'antenne. Quant au composant électronique d'interface sur le circuit imprimé, la personnalisation est mise en œuvre sans contact à travers l'antenne placée sur le circuit imprimé.

Ainsi, les opérations de personnalisation de ce type de cartes sont mises en œuvre soit au moyen de deux lecteurs, l'un adapté à la communication par contact et l'autre adapté à la communication sans contact, soit au moyen d'un lecteur adapté à la fois à la communication par contact et à la communication sans contact.

En outre, il a été vérifié que lorsque la personnalisation du circuit intégré est mise en œuvre par contact, et que celle du composant électronique sur le circuit imprimé est mise en œuvre sans contact, le rendement de la personnalisation se trouve diminué.

Par ailleurs, lorsque les personnalisations du circuit intégré et du composant électronique dans le circuit imprimé sont mises en œuvre sans contact, le temps de personnalisation augmente notablement.

On connait un autre type de carte à puce, dans laquelle le circuit intégré et le composant électronique d'interface sont montés tous les deux sur le circuit imprimé, c'est-à-dire qu'ils sont montés sur un unique substrat. Ce type de carte comporte en général une antenne permettant la communication sans contact du circuit intégré avec l'extérieur. Cette antenne est réalisée sur le même substrat que le circuit intégré et le composant électronique d'interface, et est reliée électriquement au circuit intégré.

Dans ce type de carte à puce, le circuit imprimé et l'interface de contact sont reliés mécaniquement et électriquement au moyen de points de soudure (connus en nomenclature anglo-saxonne comme « *solder bumps* »). L'interface de contact étant reliée électriquement au circuit imprimé, elle peut être reliée électriquement à tout composant électronique monté sur le circuit imprimé. La personnalisation d'une telle carte à puce, que cela concerne le circuit intégré ou d'autres composants électroniques, peut être mise en œuvre par contact à travers l'interface de contact. Ainsi, le rendement et le temps employés pour la personnalisation sont meilleurs par rapport au type de carte à puce précédent.

Toutefois, le montage et la réalisation de ces composants électroniques (le circuit intégré, l'antenne éventuelle pour permettre la communication sans contact du circuit intégré avec l'extérieur, le composant électronique d'interface) sur une seule couche, substrat ou inlay spécialise cette dernière pour une gamme spécifique de carte à puces. Les stocks de couches sont donc spécifiques et diversifiés, ce qui complique leur gestion pour la fabrication des cartes à puce.

La demande de brevet américaine US2009/200650A1 décrit un module de circuit intégré destiné à être intégré dans une carte à puce et incluant un substrat et une première puce. La première puce est placée dans une cavité d'un premier côté du substrat. Le module inclut également une deuxième puce sur un second côté du substrat.

La demande de brevet américaine US2012/255763A1 décrit une carte à puce comprenant une interface de contacts, plusieurs substrats et plusieurs composants.

La présente invention a pour but de minimiser les inconvénients précités, et de proposer un dispositif de sécurité tel qu'une carte à puce permettant de diminuer les contraintes liées à sa fabrication et à sa personnalisation.

A cet effet, la présente invention propose selon un premier aspect, un dispositif de sécurité comportant un corps et une interface de contact montée dans le corps, l'interface de contact comportant des moyens de connexion externes pour la communication avec l'extérieur du dispositif de sécurité et des moyens de connexion internes pour la communication avec l'intérieur du dispositif de sécurité, ledit dispositif de sécurité étant une carte à puce, le corps définissant le format de ladite carte à puce et comportant au moins un premier substrat et un deuxième substrat s'étendant respectivement dans des plans parallèles, et comportant respectivement au moins un premier composant électronique et un deuxième composant électronique.

Selon l'invention, l'interface de contact est reliée électriquement auxdits au moins un premier composant électronique et un deuxième composant électronique desdits au moins un premier substrat et un deuxième substrat respectivement, au moyen des moyens de connexion internes.

Ainsi, l'interface de contact est connectée à au moins un composant électrique dans chaque substrat.

Lorsque le corps comporte deux substrats, un premier substrat comportant au moins un premier composant électronique, et un deuxième substrat comportant au moins un deuxième composant électronique, l'interface de contact est connectée électriquement aux premier et deuxième composants électroniques dans le premier substrat et le deuxième substrat respectivement.

On notera que lorsque le corps comporte d'autres substrats avec au moins un composant électronique, (par exemple un troisième substrat comportant un troisième composant électronique), l'interface de contact est aussi reliée aux composants électroniques dans les autres substrats.

Par conséquent, les composants électroniques montés sur les substrats communiquant avec l'interface de contact via des moyens de connexion internes, peuvent communiquer avec l'extérieur du dispositif de sécurité à travers l'interface de contact.

Autrement dit, par exemple lorsque le corps comporte deux substrats, les premier et deuxième composants électroniques, ou d'autres composants électroniques dans les substrats leur étant reliés, peuvent communiquer avec l'extérieur au moyen de l'interface de contact, cette communication étant ainsi mise en œuvre par contact.

Ainsi, uniquement la communication par contact peut être utilisée pour la communication entre les composants électroniques des substrats, et l'extérieur, permettant d'améliorer la vitesse d'exécution et le rendement du processus de personnalisation.

En outre, les composants électroniques dans des substrat différents (par exemple le premier et deuxième composants électroniques), peuvent communiquer entre eux au moyen de l'interface de contact, ce qui permet une implémentation du dispositif de sécurité plus flexible, dès lors que les composants électroniques peuvent être montés dans l'un ou l'autre substrat en fonction des architectures des dispositifs de sécurité, et que différents types de composants électroniques peuvent être combinés dans la réalisation des dispositifs de sécurité. En conséquence, le stock de substrats et de dispositifs de sécurité fabriqués est plus aisément gérable.

Selon une caractéristique, l'interface de contact comporte une face externe affleurant une face externe dudit corps et une face interne, les moyens de connexion externes de ladite interface de contact étant disposés sur la face externe, et les moyens de connexion internes de l'interface de contact étant disposés sur la face interne.

Selon une caractéristique, le dispositif de sécurité comporte en outre un circuit intégré monté sur la face interne de l'interface de contact et relié électriquement à au moins une partie des moyens de connexion externes et internes de l'interface de contact.

Ainsi, le circuit intégré étant monté sur la face interne de l'interface de contact et relié électriquement à l'interface de contact, peut communiquer avec l'extérieur du dispositif de sécurité à travers l'interface de contact, c'est-à-dire par contact.

Par ailleurs, les premier et deuxième composants électroniques sur les premier et deuxième substrats respectivement sont connectés au circuit intégré via l'interface de contact, ces trois éléments pouvant communiquer entre eux.

Selon d'autres modes de réalisation, le circuit intégré est monté sur au moins un des substrats.

Selon une caractéristique, les moyens de connexion internes comportent au moins un premier connecteur interne et un deuxième connecteur interne, le premier connecteur interne reliant l'interface de contact audit premier composant électronique du premier substrat, et le deuxième connecteur interne reliant l'interface de contact audit deuxième composant électronique du deuxième substrat.

Les moyens de connexion internes peuvent comporter des connecteurs internes supplémentaires, pouvant relier l'interface de contact à des composants électroniques dans des substrats supplémentaires. Par exemple un troisième connecteur interne peut relier un troisième composant électronique dans un troisième substrat.

L'interface de contact est située à proximité du premier substrat et par conséquent un film conducteur est suffisant pour relier l'interface de contact audit au moins un premier composant électronique du premier substrat.

Selon une caractéristique, le dispositif de sécurité comporte un film conducteur anisotropique positionné entre la face interne de l'interface de contact et le premier substrat.

Le film conducteur anisotropique présente une épaisseur telle que l'interface de contact et le premier substrat sont reliés entre eux, mécaniquement et électriquement.

Selon une caractéristique, au moins le deuxième substrat comporte une zone de recouvrement disposée en regard d'au moins une partie des moyens de connexion internes de l'interface de contact.

Ainsi, une partie de l'interface de contact se trouve en regard d'une partie du deuxième substrat.

Par exemple, le corps peut comprendre d'autres substrats avec une zone de recouvrement disposée en regard d'au moins une partie des moyens de connexion internes de l'interface de contact.

Dans un mode de réalisation, la zone de recouvrement est disposée en regard du second connecteur interne de l'interface de contact.

Selon une autre caractéristique, le dispositif de sécurité comporte au moins une boule de soudure reliant ladite au moins une partie des moyens de connexion internes de l'interface de contact audit deuxième composant électronique du deuxième substrat au niveau de la zone de recouvrement.

La boule de soudure est ainsi située entre la face interne de l'interface de contact et la zone de recouvrement du deuxième substrat, et permet de combler l'espace existant entre l'interface de contact et le deuxième substrat et réaliser la connexion électrique entre l'interface de contact et ledit au moins un deuxième composant électronique dans le deuxième substrat.

On notera que les substrats se trouvent dans des plans parallèles, un des substrats étant situé plus proche du module que l'autre. La proximité des substrats au module est fonction de l'épaisseur des composants électroniques montés sur les substrats. En effet, la disposition des substrats entre les faces externes du corps a des contraintes dues à l'épaisseur du dispositif de sécurité.

Dans un mode de réalisation, le premier substrat est situé plus proche de l'interface de contact que le deuxième substrat. Comme indiqué ci-dessus, un film conducteur suffit pour connecter le module au premier substrat.

Quant au deuxième substrat, étant disposé plus loin, au moins une boule de soudure est utilisée pour réaliser la connexion entre l'interface de contact et le second substrat.

Si le corps comprenait un troisième substrat, au moins une boule de soudure serait aussi utilisée pour réaliser la connexion entre l'interface de contact et le troisième substrat.

Selon une caractéristique, le dispositif de sécurité comporte un film conducteur anisotropique positionné entre ladite partie des moyens de connexion internes de l'interface de contact et ladite au moins une boule de soudure.

Le film conducteur anisotropique présente une épaisseur telle que l'interface de contact et le deuxième substrat sont ainsi reliés entre eux, mécaniquement et électriquement.

Selon une caractéristique, le premier composant électronique est une antenne.

Ainsi, l'interface de contact est reliée à une antenne à travers un film conducteur anisotropique.

Lorsqu'un circuit intégré est monté et relié électriquement à l'interface de contact, le circuit intégré est relié à une antenne à travers un film conducteur anisotropique. Le circuit intégré peut ainsi communiquer avec l'extérieur sans contact, à travers cette antenne, et par contact à travers l'interface de contact.

On notera que l'épaisseur d'une antenne étant très faible, le premier substrat peut être disposé à proximité de l'interface de contact.

Selon une caractéristique, le deuxième substrat est un circuit imprimé.

Ainsi, l'interface de contact est reliée électriquement au circuit imprimé à travers des boules de soudure et un film conducteur anisotropique. Les boules de soudure permettent de combler la distance entre l'interface de contact et le circuit imprimé, cette distance étant due aux composants électroniques montés sur le circuit imprimé et à la souplesse éventuelle dudit circuit imprimé. En effet, les composants électroniques montés sur un circuit imprimé présentent une épaisseur telle que le deuxième substrat doit être positionné à distance par rapport à l'interface de contact et à la face externe du corps sur laquelle débouche l'interface de contact.

Selon une caractéristique, le premier substrat comporte au moins une cavité de substrat dans laquelle est insérée au moins une partie dudit second substrat.

L'invention concerne selon un second aspect, un procédé de fabrication d'un dispositif de sécurité comportant un corps et une interface de contact, ledit dispositif de sécurité étant une carte à puce, le corps définissant le format de ladite carte à puce et comportant au moins un premier substrat et un deuxième substrat s'étendant respectivement dans des plans parallèles, et comportant respectivement au moins un premier composant électronique et un deuxième composant électronique, l'interface de contact comportant des moyens de connexion externes pour la communication avec l'extérieur du dispositif de sécurité et des moyens de connexion internes pour la communication avec l'intérieur du dispositif de sécurité, le procédé de fabrication comportant :
- le positionnement du premier substrat et du deuxième substrat entre des couches externes du corps, et
- le positionnement de l'interface de contact dans le corps.

Selon l'invention, le procédé de fabrication comporte en outre la mise en œuvre d'une connexion électrique de l'interface de contact auxdits au moins un premier composant électronique et un deuxième composant électronique desdits au moins un premier substrat et un deuxième substrat respectivement, au moyen des moyens de connexion internes.

Selon une caractéristique, le procédé de fabrication comporte le positionnement d'un circuit intégré sur une face interne de l'interface de contact et le raccordement électrique du circuit intégré à au moins une partie des moyens de connexion externes et internes de l'interface de contact.

Selon une caractéristique, le procédé de fabrication comporte la réalisation d'au moins une cavité de substrat dans le premier substrat conçue pour recevoir au moins une partie du deuxième substrat.

Par exemple, le procédé de fabrication comporte la réalisation d'au moins une cavité de substrat conçue pour recevoir ledit au moins un deuxième composant électronique dudit deuxième substrat.

Dans un mode de réalisation, le procédé de fabrication comporte la réalisation de plusieurs cavités de substrat, chaque cavité de substrat étant conçue pour recevoir une partie du deuxième substrat, tel qu'un composant électronique monté sur le deuxième substrat.

Selon une caractéristique, ladite au moins une cavité de substrat comporte la totalité du deuxième substrat.

Selon une caractéristique, avant le positionnement du deuxième substrat entre les couches externes du corps, le procédé de fabrication comporte le positionnement d'au moins une boule de soudure sur le deuxième substrat.

Selon une caractéristique, le procédé de fabrication comporte en outre le positionnement d'un film conducteur anisotropique entre l'interface de contact et les premiers et deuxièmes substrats.

Par exemple, le film conducteur anisotropique présente une forme de couronne entourant le circuit intégré.

Le procédé de fabrication d'un dispositif de sécurité présente des caractéristiques et avantages analogues à ceux décrits précédemment en relation avec le dispositif de sécurité.

D'autres particularités et avantages de l'invention apparaîtront encore dans la description ci-après.

Aux dessins annexés, donnés à titre d'exemples non limitatifs :
- les figures 1A et 1B représentent schématiquement des cartes à puce de l'art antérieur ;
- la figure 2A représente schématiquement une carte à puce selon un premier mode de réalisation de l'invention ;
- la figure 2B représente schématiquement une carte à puce selon un deuxième mode de réalisation de l'invention ;
- la figure 3 est une vue partielle en coupe d'une carte à puce selon le mode de réalisation représenté à la figure 2A ; et
- la figure 4 est une vue schématique du module selon un mode de réalisation de l'invention.

La présente invention s'applique à tout type de carte à puce, et notamment à des cartes à puce comportant au moins deux substrats, couches ou inlays, comportant chacun au moins un composant électronique. Elle trouve son utilité dans des cartes à puce pouvant communiquer avec l'extérieur par contact et/ou sans contact.

On notera que dans les modes de réalisation qui vont être décrits ci-dessous, la carte à puce comporte deux substrats. Néanmoins, l'invention s'applique aussi à des cartes à puce comportant un nombre de substrats supérieur à deux.

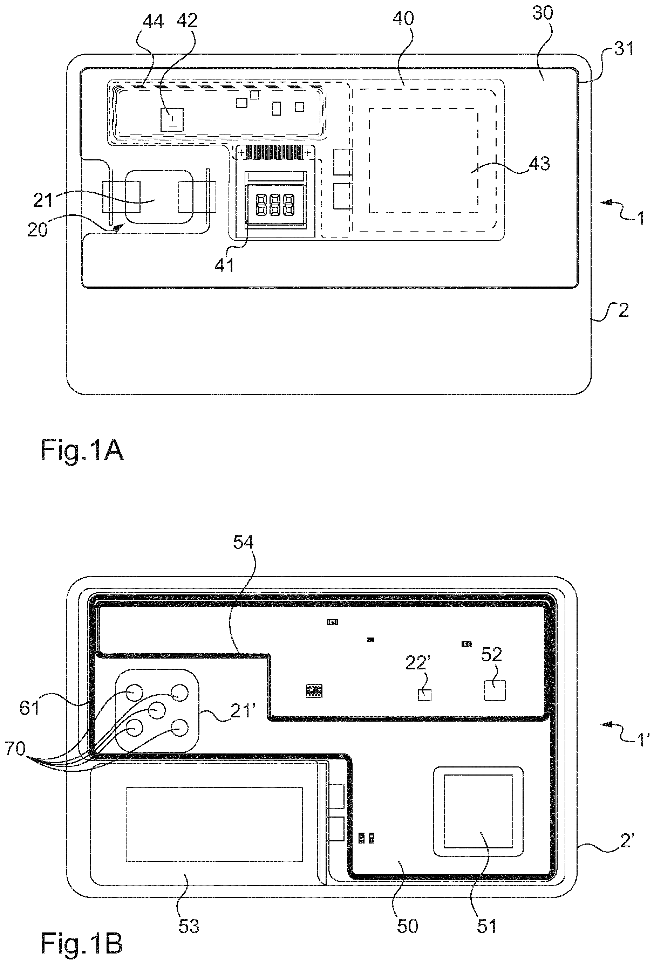

On va d'abord présenter, en référence aux figures 1A et 1B, le contexte dans lequel s'applique l'invention.

La **figure 1A** représente un dispositif de sécurité 1 de l'art antérieur.

Le dispositif de sécurité est une carte à puce 1 comportant un corps de carte 2 et un module 20 monté dans le corps de carte 2. Le module 20 est formé dans un mode de réalisation par une interface de contact 21 pour la communication avec l'extérieur de la carte à puce 1, et un circuit intégré (non visible sur la figure). Le circuit intégré est monté sur une face interne de l'interface de contact et est relié électriquement à l'interface de contact 21 de sorte que le circuit intégré peut communiquer avec l'extérieur de la carte à puce 1 via l'interface de contact 21.

On notera que les différents éléments de la carte à puce 1 sont illustrés schématiquement et que tous les éléments ne sont pas visibles.

Le corps de carte 2 représenté à la figure 1A comporte deux couches extérieures dont seulement une est visible sur la figure 1A, en général en matériaux plastiques. Dans la carte à puce illustrée, deux substrats, inlays ou couches sont disposés entre les deux couches extérieures.

Dans la carte à puce de l'art antérieur représentée, le corps de carte 2 comporte un premier substrat 30 et un deuxième substrat 40 s'étendant respectivement dans des plans parallèles.

On notera que dans les cartes à puce, les substrats peuvent subir de légères déformations lors de leur intégration dans le corps de carte. Ainsi, dans ce document, un substrat s'étendant dans un plan doit être compris comme s'étendant sensiblement dans un plan.

En pratique, chaque substrat est compris entre deux plans parallèles, nommés « plans de tolérance », distants l'un de l'autre d'une valeur de tolérance donnée. Cette valeur de tolérance donnée est tellement basse qu'il peut être considéré que le substrat s'étend dans un plan.

Par ailleurs, lorsque l'on se réfère à des « plans parallèles », les plans de tolérance d'un substrat sont respectivement parallèles aux plans de tolérance de l'autre substrat.

Dans un mode de réalisation, le premier substrat 30 comporte une antenne 31. Cette antenne 31 est formée par des fils conducteurs réalisés sur le premier substrat 30 et est reliée au module 20 de sorte que l'antenne peut servir à la communication sans contact du circuit intégré 22 dans le module 20 avec l'extérieur de la carte à puce 1.

Dans le mode de réalisation décrit, le deuxième substrat 40 comporte un circuit imprimé flexible dans lequel des composants électroniques sont montés. On notera que le circuit imprimé flexible forme le deuxième substrat 40 et que la même référence numérique est utilisée pour désigner les deux éléments.

Sur la figure 1A, le circuit imprimé flexible 40 comporte notamment un afficheur 41, un microcontrôleur 42 gérant le fonctionnement de l'afficheur 41, et une batterie 43 stockant de l'énergie nécessaire pour le fonctionnement des composants électroniques sur ce deuxième substrat 40.

Le deuxième substrat 40 comporte en outre une antenne 44, formée par des pistes conductrices réalisées sur le deuxième substrat 40. Cette antenne 44 est destinée à la communication sans contact des composants électroniques sur le circuit imprimé flexible 40 avec l'extérieur de la carte à puce 1. Par exemple, des opérations de personnalisation des composants électroniques du circuit imprimé flexible 40 nécessaires pour la fabrication de la carte à puce 1, sont mises en œuvre à travers cette antenne 44.

Cette antenne 44 peut être similaire ou différente de l'antenne 31 du premier substrat ou inlay d'antenne 30.

Une cavité d'interface est réalisée dans une couche extérieure (non visible sur la figure) de la carte à puce 1, dans laquelle le module 20 y est logé. Le module 20 débouche ainsi sur une face externe du corps de carte 2, et affleure cette face externe.

On notera que dans la carte à puce 1 représentée sur la figure 1A, le circuit intégré du module 20 peut communiquer avec l'extérieur de la carte à puce 1 par contact à travers une interface de contact 21 ou sans contact à travers l'antenne 31 dans le premier substrat 30.

Le circuit imprimé flexible 40 peut communiquer avec l'extérieur de la carte à puce 1 sans contact à travers son antenne 44.

On notera que le premier substrat 30 et le deuxième substrat 40 ne sont pas reliés entre eux et que le module 20 n'a aucune connexion avec le circuit imprimé flexible 40.

La **figure 1B** représente un deuxième dispositif de sécurité 1' de l'art antérieur.

Ce dispositif de sécurité 1' est similaire au dispositif de sécurité 1 décrit en référence à la figure 1A, et présente comme différence principale que le circuit intégré 22' ne se trouve pas monté sur l'interface de contact 21', mais sur l'un des substrats.

Dans cette carte à puce 1' de l'art antérieur, le corps de carte 2' comporte un substrat 50 de type circuit imprimé. Sur le substrat 50 sont montés différents composants électroniques, tels que le circuit intégré 22', un composant électronique d'interface 51, tel qu'un capteur d'empreinte digitale, un microcontrôleur 52 gérant l'acquisition des empreintes digitales avec le capteur d'empreinte digitale 51, une batterie 53, et une antenne 54 reliée au microcontrôleur 52.

Le substrat 50 comporte également une antenne 61. L'antenne 61 est reliée par des pistes conductrices au circuit intégré 22', de sorte que l'antenne 61 peut servir à la communication sans contact du circuit intégré 22'.

Le substrat 50 comporte en outre plusieurs connecteurs 70 pour la réalisation de la connexion des composants électroniques sur le substrat 50 avec l'interface de contact 21'.

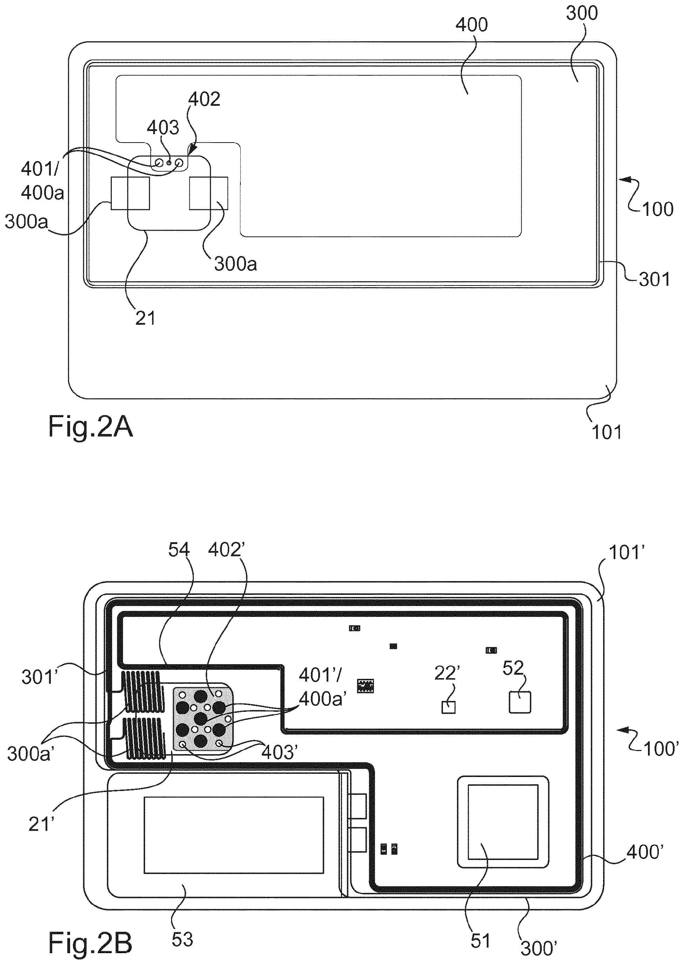

La **figure 2A** représente schématiquement une carte à puce 100 selon un premier mode de réalisation de l'invention.

La carte à puce 100 illustrée comporte un corps de carte 101 et une interface de contact 21 montée dans le corps de carte 101.

Dans ce mode de réalisation, un circuit intégré (non visible sur la figure) est monté sur une face interne de l'interface de contact 21. L'ensemble formé par l'interface de contact 21 et le circuit intégré est nommé module.

Le corps de carte 101 comporte un premier substrat 300 et un deuxième substrat 400 s'étendant respectivement dans des plans parallèles.

Comme indiqué ci-dessus en référence à la figure 1A, en pratique les plans de tolérance d'un substrat sont respectivement parallèles aux plans de tolérance de l'autre substrat.

Bien entendu, comme indiqué ci-dessus, le nombre de substrats dans le corps de carte peut être supérieur à deux. Ainsi, dans d'autres modes de réalisation non représentés, le corps de carte comporte d'autres substrats supplémentaires.

Dans un mode de réalisation, le premier substrat 300 comporte une antenne 301 dédiée notamment à la communication entre le module 20 et l'extérieur de la carte à puce 100, en particulier à la communication entre le circuit intégré et l'extérieur de la carte à puce 100. Le deuxième substrat 400 comporte un circuit imprimé flexible sur lequel sont montés des composants électroniques.

On entend par composant électronique tout composant électronique monté sur les substrats ayant un rôle dans le fonctionnement de la carte à puce 100. Ainsi, le composant électronique peut être une antenne, un circuit intégré, un microcontrôleur, un afficheur, une batterie, des pistes conductrices, des fils conducteurs ou autre.

L'antenne 301 est formée par des fils conducteurs réalisés sur le premier substrat 300 et se compose d'aires de connexion 300a, réalisées en matériau conducteur. L'aire de connexion 300a correspond à un mode de réalisation de l'antenne 301 sur le substrat 300 pour faciliter sa connexion avec le module 20, en particulier avec l'interface de contact 21.

D'autres modes de réalisation de l'antenne 301 sont possibles pour faciliter sa connexion avec l'interface de contact 21. Ainsi, dans un autre mode de réalisation, l'aire de connexion 300a peut comporter le prolongement des fils conducteurs qui forment l'antenne 301 en faisant plusieurs passages dans la zone de surface du substrat 300 où sera réalisée la connexion avec l'interface de contact 21. Bien entendu, tout autre composant électronique peut être employé pour la mise en œuvre de l'aire de connexion 300a.

Ces modes de réalisation de la connexion entre l'antenne et l'interface de contact ne seront pas décrits davantage dans ce document car ils sont connus de l'homme du métier.

Le circuit intégré du module 20 et certains composants électroniques du substrat 400 (tels la batterie, le microcontrôleur, etc.) ne sont pas représentés sur cette figure, ces composants électroniques pouvant correspondre, par exemple, aux composants électroniques décrits en référence à la figure 1A.

Comme décrit en référence à la figure 1A, le circuit imprimé flexible forme le deuxième substrat 400 et la même référence numérique est utilisée pour désigner les deux éléments.

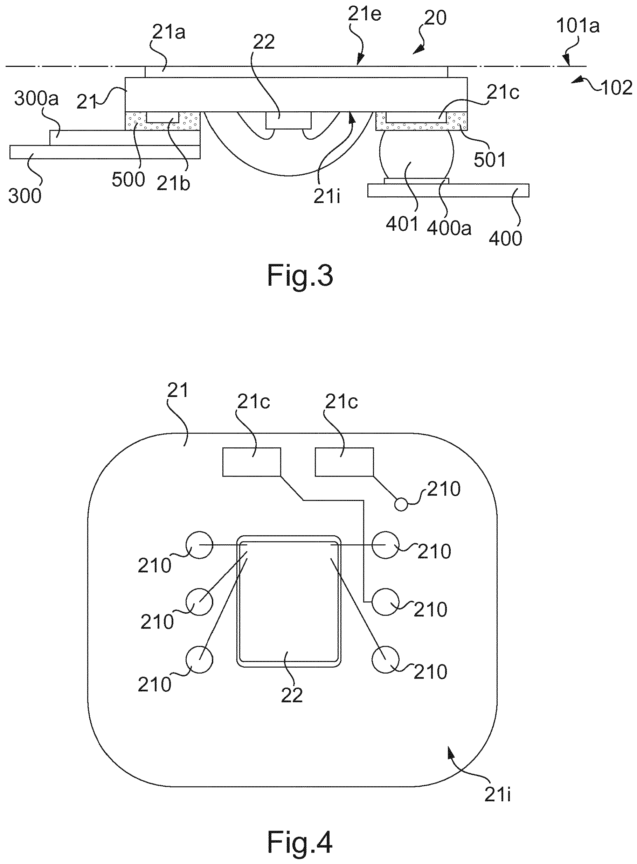

Le module 20 peut être visualisé sur la figure 3. La **figure 3** illustre schématiquement une vue de coupe d'une partie de la carte à puce 100 dans laquelle le module 20 et une partie des substrats 300, 400 sont visibles. Le module 20 comporte une interface de contact 21 et un circuit intégré 22.

Dans ce mode de réalisation, le module 20 est situé dans une cavité d'interface (non visible sur la figure) réalisée dans une couche ou plusieurs couches incluant une couche extérieure 102 du corps de carte 101, et/ou les substrats 300, 400. L'interface de contact 21 débouche sur une face externe 101a du corps de carte 101 et une face externe 21e de l'interface de contact 21 affleure cette face externe 101a du corps de carte 101.

L'interface de contact 21 comporte en outre des moyens de connexion externes 21a pour la communication avec l'extérieur de la carte à puce 100 et des moyens de connexion interne 21b, 21c pour la communication avec l'intérieur de la carte à puce 100. Les moyens de connexion internes 21b, 21c ainsi que le circuit intégré 22, sont disposés sur une face interne de l'interface de contact 21.

Dans le mode de réalisation représenté, les moyens de connexion internes comportent un premier connecteur interne 21b reliant l'interface de contact 21 au premier substrat 300, en particulier à l'antenne 301 du premier substrat 300, via l'aire de connexion 300a. Les moyens de connexion internes comportent en outre un deuxième connecteur interne 21c reliant l'interface de contact 21 au deuxième substrat 400, en particulier à au moins un des composants électroniques dans le deuxième substrat 400, via un composant électronique 400a dans le deuxième substrat 400.

Bien entendu, lorsque le corps de carte comporte des substrats supplémentaires, les moyens de connexion internes comportent des connecteurs internes supplémentaires pour relier l'interface de contact aux composants électroniques dans les substrats supplémentaires.

Dans le mode de réalisation décrit, le composant électronique 400a est une piste conductrice réalisée sur le deuxième substrat 400 permettant la connexion de l'interface de contact 21 à un composant électronique sur le deuxième substrat 400.

Ainsi, l'interface de contact 21 est reliée électriquement à l'antenne 301 du premier substrat 300 (via son aire de connexion 300a) et à au moins un composant électronique du deuxième substrat 400 (via le composant électronique 400a) à travers les moyens de connexion internes 21b, 21c.

On notera qu'un seul premier connecteur interne 21b et un seul deuxième connecteur interne 21c sont représentés sur la figure 3. Néanmoins, plusieurs connecteurs pourraient former le premier connecteur interne 21b et/ou plusieurs connecteurs pourraient former le deuxième connecteur interne 21c.

En outre, au moins une boule de soudure 401 relie le deuxième connecteur interne 21c de l'interface de contact 21 au deuxième substrat 400. Cette au moins une boule de soudure 401 a des dimensions telles que l'interface de contact 21, en particulier le connecteur interne 21c de l'interface de contact 21, est en contact avec le deuxième substrat 400.

Selon des modes de réalisation, ladite au moins une boule de soudure peut être un plot de soudure (connu en nomenclature anglo-saxonne comme « *solder bump* »), une boule de colle conductrice (connu en nomenclature anglo-saxonne comme *« flex bump* »), un plot ou pastille de cuivre (connu en nomenclature anglo-saxonne comme « *copper piller* ») ou autres.

La taille de la boule de soudure 401 est déterminée en fonction de la distance entre l'interface de contact 21 et le circuit imprimé 400 et des dimensions des moyens de connexion interne 21c de l'interface de contact 21. En outre, la détermination est mise en œuvre en tenant compte du courant électrique maximale qui passera via cette boule de soudure. Il est aussi tenu compte de la taille de la surface de contact de la boule de soudure 401 avec le connecteur interne 21c de l'interface de contact 21 ou le film conducteur anisotropique, et de l'effet d'écrasement de la boule de soudure 401 lors de l'assemblage du corps de carte 101.

Par ailleurs, la détermination est mise en œuvre en tenant compte des valeurs nominales, et des marges de tolérances associées pour les distances et dimensions de tous les éléments constitutifs de la carte à puce 100.

A titre d'exemple nullement limitatif, la taille type des boules de soudure présente une valeur entre 200 et 250 µm. Bien entendu, ces valeurs peuvent être différentes.

Du fait des contraintes d'épaisseur des cartes à puce, les substrats 300, 400 ne sont pas situés en regard de la totalité de l'interface de contact 21 et/ou du circuit intégré 22.

En outre, comme cela peut être visualisé sur la figure 4, le circuit intégré 22 et l'interface de contact 21 sont reliés électriquement par des fils électriques réalisés sur la face interne 21i de l'interface de contact 21.

Lors de la fabrication de la carte à puce, il est évité de superposer des composants électriques à ces fils électriques de connexion entre le circuit imprimé 22 et l'interface de contact 21.

Dans le mode de réalisation décrit, le deuxième substrat 400 comporte une zone de recouvrement 402 (figure 2A) disposée en regard d'une partie de l'interface de contact 21.

Sur la zone de recouvrement 402 sont posées des pistes conductrices 400a, les boules de soudure 401 étant posées sur les pistes conductrices 400a.

Dans un mode de réalisation, la surface de recouvrement 402 comporte des trous perforés 403. Ces trous perforés 403 permettent une meilleure adhésion de l'interface de contact 21 et de la zone de recouvrement 402, avec le corps de carte 101.

La zone de recouvrement 402 présente une taille telle qu'elle peut loger une ou plusieurs boules de soudure 401 pour la connexion du deuxième substrat 400 à l'interface de contact 21.

La surface de la zone de recouvrement 402 est déterminée en fonction du nombre et de la taille de trous perforés 403, de la taille et du nombre de boules de soudure 401 faisant la connexion entre l'interface de contact 21 et le composant électronique 400a du deuxième substrat 400.

A titre d'exemple nullement limitatif, la surface occupée par l'ensemble de boules de soudure 401 est de 6,25 mm² et la surface de la zone de recouvrement est de 12,5 mm².

Par exemple, le ratio entre la surface occupée par l'ensemble de boules de soudure 401 et la zone de recouvrement 402 présente une valeur comprise entre 0.2 et 0.7.

En particulier, la zone de recouvrement 402 est disposée en regard du second connecteur interne 21c de l'interface de contact 21.

Dans ce mode de réalisation, et tel que visible sur la figure 3, ladite au moins une boule de soudure 401 est située entre le connecteur interne 21c de l'interface de contact 21 et le deuxième substrat 400.

Dans d'autres modes de réalisation non illustrés, les composants électroniques de substrats supplémentaires sont également reliés aux moyens de connexion internes de l'interface de contact.

Par exemple, dans un mode de réalisation, un troisième substrat est positionné dans le même plan que le deuxième substrat, le troisième et deuxième substrat ayant chacun une zone de recouvrement en regard d'une partie distincte des moyens de connexion interne de l'interface de contact.

Dans un autre exemple de réalisation, le troisième substrat est positionné dans un plan parallèle au premier et deuxième substrat et les boules de soudures utilisées pour la connexion de l'interface de contact avec le troisième substrat sont ainsi de tailles différentes de celles utilisées pour la connexion de l'interface de contact avec le deuxième substrat. On notera que dans cet exemple, les deuxième et troisième substrats se trouvent à des distances différentes de l'interface de contact et que les tailles des boules de soudures utilisées sont adaptées en fonction de la distance à combler entre chaque substrat et l'interface de contact.

Les modes de réalisations qui viennent d'être donnés, avec les variantes envisagées, ne constituent que des exemples possibles de mise en œuvre de l'invention qui ne s'y limite pas.

La **figure 4** représente une vue de face de la face interne 21i de l'interface de contact 21.

Ainsi, sur cette figure on visualise le circuit intégré 22 positionné sur une partie centrale de l'interface de contact 21. Des connecteurs 210 sont disposés sur la face interne 21i de l'interface de contact 21.

Une partie de ces connecteurs 210 sont utilisés pour la connexion électrique entre le circuit intégré 22 et l'interface de contact 21.

Ces connexions électriques ne seront pas décrites davantage dans ce document dès lors que la réalisation d'un module comportant une interface de contact 21 et un circuit intégré 22, et des connexions entre l'interface de contact 21 et le circuit intégré 22 est connue de l'homme du métier.

Dans un mode de réalisation, l'interface de contact 21 comporte deux connecteurs internes 21c. Les connecteurs internes 21c correspondent respectivement à des connecteurs 210 de l'interface de contact 21 qui ont été déportés de sorte que les connecteurs internes 21c sont disposés en regard de la zone de recouvrement 402 du deuxième substrat 400.

Ainsi, la connexion de l'interface de contact 21 avec le deuxième substrat 400 peut être réalisée de façon aisée sans prendre le risque de réaliser des contacts non souhaités avec d'autres parties de l'interface de contact 21.

Revenant à la figure 3, dans le mode de réalisation décrit, des films conducteurs anisotropiques 500, 501 sont positionnés entre la face interne 21i de l'interface de contact 21 et l'aire de connexion 300a, et entre la face interne 21i de l'interface de contact 21 et la boule de soudure 401. Dans un mode de réalisation, le film conducteur anisotropique 500, 501 est un adhésif permettant de relier mécaniquement et électriquement l'interface de contact 21 au premier substrat 300 et au deuxième substrat 400.

En outre, le film conducteur anisotropique 500, 501 permet de combler l'espace vide entre les différents éléments à relier dans la carte à puce 100, en particulier entre le premier substrat 300 et l'interface de contact 21, et entre un ensemble formé par le deuxième substrat 400 et la boule de soudure 401, et l'interface de contact 21.

Dans d'autres modes de réalisation, une colle conductrice peut être utilisée au lieu du film conducteur anisotropique pour combler l'espace vide entre les différents éléments à relier dans la carte à puce 100, en particulier entre le premier substrat 300 et l'interface de contact 21, et entre l'ensemble formé par le deuxième substrat 400 et la boule de soudure 401, et l'interface de contact 21.

Dans un mode de réalisation, et toujours du fait des contraintes de l'épaisseur des cartes à puce, le deuxième substrat 400 est situé dans une cavité de substrat réalisée dans le premier substrat 300. En effet, l'antenne 301 dans le premier substrat 300 étant située sur la périphérie du premier substrat 300, la cavité de substrat est réalisée dans la partie centrale du premier substrat 300.

On notera que les composants électroniques montés sur le circuit imprimé flexible 400 ont une certaine épaisseur et que superposer la totalité des deux substrats augmenterait l'épaisseur de la carte à puce.

En outre, la superposition de substrats est limitée par les composants électroniques situés dans les différents substrats.

Ainsi, dans le mode de réalisation décrit, l'antenne 301 dans le premier substrat 300 et les composants électroniques situés sur le circuit imprimé flexible 400 ne se superposent pas.

Bien entendu, dans d'autres modes de réalisation, l'antenne dans le premier substrat 300 et une partie ou la totalité des composants électroniques situés sur le circuit imprimé 400 peuvent se superposer.

On notera que la superposition ou non superposition des composants est mise en œuvre en fonction des contraintes liées à l'épaisseur de la carte à puce 100.

La **figure 2B** représente schématiquement une carte à puce 100' selon un deuxième mode de réalisation de l'invention.

Sur la carte à puce représentée sur la figure 2B, certains éléments se trouvant placés sous des couches opaques, sont représentés visibles afin de clarifier la description des différents éléments de la carte à puce.

La carte à puce 100' comporte un corps de carte 101', le corps de carte 101' comportant un premier substrat 300' et un deuxième substrat 400'. Le premier substrat 300' et le deuxième substrat 400' s'étendent respectivement dans des plans parallèles

On notera que dans ce mode de réalisation, le circuit intégré 22' est monté sur le deuxième substrat, alors que dans le mode de réalisation représenté à la figure 2A le circuit intégré est monté sur l'interface de contact.

Sur la figure 2B, l'interface de contact n'est pas représentée, la référence 21' représentant la position où la cavité d'interface recevant l'interface de contact est creusée. Ainsi, dans cette description, la référence 21' se réfère à l'interface de contact.

Dans le mode de réalisation décrit, le premier substrat 300' comporte une antenne 301' dédiée à la communication du circuit intégré 22' avec l'extérieur de la carte à puce 100'.

Dans le mode de réalisation décrit, le deuxième substrat 400' comporte un circuit imprimé flexible sur lequel sont montés des composants électroniques, tels que le circuit imprimé 22'.

Sur le deuxième substrat 400, sont montés d'autres composants électroniques tels qu'un capteur d'empreinte digitale 51, un microcontrôleur 52 gérant l'acquisition des empreintes digitales avec le capteur 51, une batterie 53 ou une antenne 54 permettent la communication sans contact de certains composants électroniques avec l'extérieur de la carte à puce 100'.

Le premier substrat 300' et le deuxième substrat 400' se trouvant superposés l'un par rapport à l'autre, des cavités de substrat sont réalisées dans le premier substrat 300' afin d'y loger des composants électroniques montés sur le deuxième substrat 400'.

Comme pour le mode de réalisation décrit en référence à la figure 2A, l'antenne 301' est formée par des fils conducteurs réalisés sur le premier substrat 300', et le premier substrat 300' comporte des aires de connexion 300a' réalisées en matériau conducteur. Ces aires de connexion 300a' sont destinées à la connexion entre l'antenne 301' du premier substrat 300' et l'interface de contact 21'.

Dans un mode de réalisation, l'aire de connexion 300a' comporte le prolongement des fils conducteurs qui forment l'antenne 301' faisant plusieurs passages dans la zone de surface du premier substrat 300' où sera réalisée la connexion avec l'interface de contact 21'.

Bien entendu, d'autres modes de réalisation sont possibles pour la réalisation de la connexion entre l'antenne 301' dans le premier substrat 300' et l'interface de contact 21'.

Le deuxième substrat 400' comporte une zone de recouvrement 402' disposée en regard d'une partie de l'interface de contact 21'. Sur cette zone de recouvrement 402' sont réalisés des connecteurs 401'/400a' dédiés à la connexion du deuxième substrat 400' avec l'interface de contact 21'.

La connexion entre l'interface de contact 21' et le substrat 300', 400' est réalisée de façon similaire à celle décrite en référence à la figure 3.

On notera que la figure 3 représente la connexion entre l'interface de contact 21 et les substrats 300, 400 pour la carte à puce 100 représentée à la figure 2A (un circuit intégré est monté sur l'interface de contact 21). Néanmoins, la connexion entre l'interface de contact et les substrats 300', 400' est similaire pour la carte à puce 100' représentée à la figure 2B.

Ainsi, des boules de soudure 401' sont posées sur des pistes conductrices 400a', l'ensemble des deux étant placé sur la zone de recouvrement 402'.

Comme pour le premier mode de réalisation, la zone de recouvrement présente une taille telle qu'elle peut loger une ou plusieurs boules de soudure 401' pour la connexion du deuxième substrat 400' à l'interface de contact 21'.

Dans un mode de réalisation, la surface de recouvrement 402' comporte des trous perforés 403'. Ces trous perforés 403' permettent une meilleure adhésion de l'interface de contact 21' et de la zone de recouvrement 402' avec le corps de carte 101'. A titre d'exemple nullement limitatif, le nombre de trous perforés 403' est ici de 9. La surface occupée par les trous est de 7 mm^{2,} chaque trou perforé 403' ayant un diamètre minimum de 500um, par exemple 1mm.

La surface de la zone de recouvrement 402' est déterminée en fonction du nombre et de la taille des trous perforés 403', de la taille et du nombre de boules de soudure 401' faisant la connexion entre l'interface de contact 21' et le composant électronique 400a' du deuxième substrat 400'.

A titre d'exemple nullement limitatif, le nombre de boules de soudure est ici de 7, la surface occupée par les boules de soudure est de 22 mm² et la surface de la zone de recouvrement est de 71,2 mm².

Par exemple, le ratio entre la surface occupée par l'ensemble de boules de soudure 401' et la zone de recouvrement 402' présente une valeur comprise entre 0.2 et 0.7.

Par exemple, le ratio entre la surface occupée par l'ensemble des trous perforés 403' et la zone de recouvrement 402' présente une valeur comprise entre 0.01 à 0.5.

Comme pour les modes de réalisation décrits en référence à la figure 2A, le corps du dispositif de sécurité peut comporter un nombre supérieur de substrats, au moins un composant électronique dans les substrats étant relié à l'interface de contact.

Lorsqu'une carte à puce 100' telle que celle représentée par la figure 2B est fabriquée, une ou plusieurs cavités de substrat sont créées dans le premier substrat 300' conçues pour recevoir une partie des composants électroniques placés sur le deuxième substrat. On notera, que les composants électroniques placés dans les cavités de substrat correspondent à ceux dont l'épaisseur augmenterait l'épaisseur de la carte à puce au-delà de l'épaisseur donnée, par exemple au-delà de l'épaisseur permise par les normes.

Le premier substrat 300,300' et le deuxième substrat 400,400' sont positionnés entre des couches extérieures 102 du corps de carte 101,101'.

En outre, une cavité d'interface est réalisée dans une couche ou plusieurs couches incluant une couche extérieure 102 du corps de carte 101,101' et/ou les substrats 300,300', 400,400' configurée pour recevoir l'interface de contact 21,21'.

L'interface de contact 21,21' est insérée dans la cavité d'interface de sorte qu'elle affleure la face externe 101a du corps de carte 101,101'.

Avant l'insertion de l'interface de contact 21,21' dans la cavité d'interface, le procédé de fabrication de la carte à puce 100,100' comporte, selon un mode de réalisation, le positionnement d'un film conducteur anisotropique 500 sur le premier connecteur interne 21b.

En outre, un deuxième film conducteur anisotropique 501 est positionné sur le deuxième connecteur interne 21c de l'interface de contact 21, 21', et au moins une boule de soudure 401,401' est positionnée entre le deuxième film conducteur anisotropique 501 et le circuit imprimé flexible 400,400'.

Dans un mode de réalisation, le positionnement du deuxième film conducteur anisotropique 501 sur l'interface de contact 21,21' et de ladite au moins une boule de soudure 401,401' sur le circuit imprimé flexible 400,400' est mise en œuvre avant de placer le circuit imprimé flexible 400, 400' et l'interface de contact 21,21' dans le corps de carte 101, 101'.

Dans un mode de réalisation, le premier conducteur anisotropique 500 et le deuxième film conducteur anisotropique 501 forment un anneau adhésif. Dans un mode de réalisation dans lequel un circuit intégré 22 est monté sur la face interne 21i de l'interface de contact 21, cet anneau adhésif 500,501 entoure le circuit intégré 22.

Du procédé de fabrication décrit ci-dessus résulte une carte à puce 100, 100' selon un mode de réalisation et telle que représentée sur les figures. Dans cette carte à puce 100, 100', le premier substrat 300,300' et le deuxième substrat 400,400' sont reliés à l'interface de contact 21,21', le circuit intégré 22,22' et les composants électroniques sur le deuxième substrat 400,400' pouvant communiquer par contact avec l'extérieur de la carte à puce 100, 100'.

## Revendications

1. Dispositif de sécurité comportant un corps (101,101') et une interface de contact (21,21') montée dans ledit corps (101,101'), ladite interface de contact (21,21') comportant des moyens de connexion externes (21a) pour la communication avec l'extérieur dudit dispositif de sécurité (100,100') et des moyens de connexion internes (21b, 21c) pour la communication avec l'intérieur dudit dispositif de sécurité (100,100'), ledit dispositif de sécurité (100,100') étant une carte à puce,
ledit corps (101, 101') définissant le format de ladite carte à puce (100,100') et comportant au moins un premier substrat (300,300') et un deuxième substrat (400, 400') s'étendant respectivement dans des plans parallèles, et comportant respectivement au moins un premier composant électronique (300a, 300a', 301, 301') et un deuxième composant électronique (400a, 400a', 41, 42, 43, 44, 51, 52, 53, 54, 22'),
ledit dispositif de sécurité (100,100') étant **caractérisé en ce que** ladite interface de contact (21, 21') est reliée électriquement auxdits au moins un premier composant électronique (300a, 300a', 301, 301') et un deuxième composant électronique (400a, 400a', 41, 42, 43, 44, 51, 52, 53, 54, 22') desdits au moins un premier substrat et un deuxième substrat (400, 400') respectivement, au moyen desdits moyens de connexion internes (21b, 21c).

2. Dispositif de sécurité conforme à la revendication 1, **caractérisé en ce que** ladite interface de contact (21,21') comporte une face externe (21e) affleurant une face externe (101a) dudit corps (101,101') et une face interne (21i), lesdits moyens de connexion externes (21a) de ladite interface de contact (21, 21') étant disposés sur ladite face externe (21e), et lesdits moyens de connexion internes (21b, 21c) de ladite interface de contact (21,21') étant disposés sur ladite face interne (21i).

3. Dispositif de sécurité conforme à la revendication 2, **caractérisé en ce qu'**il comporte en outre un circuit intégré (22) monté sur ladite face interne (21i) de ladite interface de contact (21) et relié électriquement à au moins une partie desdits moyens de connexion externes (21a) et internes (21b, 21c) de ladite interface de contact (21).

4. Dispositif de sécurité conforme à l'une des revendications 1 à 3, **caractérisé en ce que** les moyens de connexion internes (21b, 21c) comportent au moins un premier connecteur interne (21b) et un deuxième connecteur interne (21c), ledit premier connecteur interne (21b) reliant ladite interface de contact (21, 21') audit premier composant électronique (300a, 300a', 301, 301') dudit premier substrat (300, 300'), et ledit deuxième connecteur interne (21c) reliant ladite interface de contact (21, 21') audit deuxième composant électronique dudit deuxième substrat (400, 400').

5. Dispositif de sécurité conforme à l'une des revendications 1 à 4, **caractérisé en ce qu'**il comporte un film conducteur anisotropique (500) positionné entre la face interne (21i) de ladite interface de contact (21,21') et ledit premier substrat (300 ; 300').

6. Dispositif de sécurité conforme à l'une des revendications 1 à 5, **caractérisé en ce que** au moins ledit deuxième substrat (400, 400') comporte une zone de recouvrement (402, 402') disposée en regard d'au moins une partie des moyens de connexion internes (21c) de l'interface de contact (21, 21').

7. Dispositif de sécurité conforme à la revendication 6, **caractérisé en ce qu'**il comporte au moins une boule de soudure (401 ; 401') reliant ladite partie des moyens de connexion internes (21c) de ladite interface de contact (21 ; 21') audit deuxième composant électronique dudit deuxième substrat (400 ; 400') au niveau de ladite zone de recouvrement (402 ; 402').

8. Dispositif de sécurité conforme à la revendication 7, **caractérisé en ce qu'**il comporte un film conducteur anisotropique (501) positionné entre ladite partie des moyens de connexion interne (21c) de ladite interface de contact (21 ; 21') et ladite au moins une boule de soudure (401 ; 401').

9. Dispositif de sécurité conforme à l'une des revendications 1 à 8, **caractérisé en ce que** ledit premier substrat (300,300') comporte au moins une cavité de substrat dans laquelle est insérée au moins une partie dudit second substrat (400,400').

10. Procédé de fabrication d'un dispositif de sécurité comportant un corps (101 ; 101') et une interface de contact (21 ; 21'), ledit dispositif de sécurité (100,100') étant une carte à puce, ledit corps (101 ; 101') définissant le format de ladite carte à puce (100,100') et comportant au moins un premier substrat (300 ; 300') et un deuxième substrat (400 ; 400') s'étendant respectivement dans des plans parallèles, et comportant respectivement au moins un premier composant électronique (300a, 300a', 301, 301') et un deuxième composant électronique (400a, 400a', 41, 42, 43, 44, 51, 52, 53, 54, 22'), et ladite interface de contact (21 ; 21') comportant des moyens de connexion externes (21a) pour la communication avec l'extérieur dudit dispositif de sécurité (100 ; 100') et des moyens de connexion internes (21b, 21c) pour la communication avec l'intérieur dudit dispositif de sécurité (100; 100'), ledit procédé de fabrication comportant :
- le positionnement dudit premier substrat (300 ; 300') et dudit deuxième substrat (400 ; 400') entre des couches externes (102) dudit corps (101 ; 101'), et
- le positionnement de ladite interface de contact (21, 21') dans ledit corps (101 ; 101'),
ledit procédé de fabrication étant **caractérisé en ce qu'**il comporte en outre la mise en œuvre d'une connexion électrique de ladite interface de contact (21 ; 21') auxdits au moins un premier composant électronique (300a, 300a', 301 ; 301') et un deuxième composant électronique (400a ; 400a', 41, 42, 43, 44, 51, 52, 53, 54, 22') desdits au moins un premier substrat (300 ; 300') et un deuxième substrat (400 ; 400') respectivement, au moyen desdits moyens de connexion internes (21b, 21c).

11. Procédé de fabrication conforme à la revendication 10, **caractérisé en ce qu'**il comporte le positionnement d'un circuit intégré (22) sur une face interne (21i) de ladite interface de contact (21) et le raccordement électrique dudit circuit intégré (22) à au moins une partie desdits moyens de connexion externes (21a) et internes (21b, 21c) de ladite interface de contact (21').

12. Procédé de fabrication conforme à l'une des revendications 10 ou 11, **caractérisé en ce qu'**il comporte la réalisation d'au moins une cavité de substrat dans ledit premier substrat (300 ; 300') conçue pour recevoir au moins une partie dudit deuxième substrat (400 ; 400').

13. Procédé de fabrication conforme à l'une des revendications 10 à 12, **caractérisé en ce qu'**il comporte la réalisation d'au moins une cavité de substrat dans ledit premier substrat (300, 300') conçue pour recevoir au moins un composant électronique (400a, 400a', 41, 42, 43, 44, 51, 52, 53, 54, 22') dudit deuxième substrat (400, 400').

14. Procédé de fabrication conforme à l'une des revendications 10 à 13, **caractérisé en ce qu'**avant ledit positionnement dudit deuxième substrat (400; 400') entre les couches externes (102) dudit corps (101, 101'), ledit procédé de fabrication comporte le positionnement d'au moins une boule de soudure (401 ; 401') sur ledit deuxième substrat (400 ; 400').

15. Procédé de fabrication conforme à la revendication 14, **caractérisé en ce qu'**il comporte en outre le positionnement d'un film conducteur anisotropique (500,501) entre ladite interface de contact (21 ; 21') et lesdits premier substrat (300 ; 300') et deuxième substrat (400 ; 400').

## Patentansprüche

1. Sicherheitsvorrichtung, umfassend einen Körper (101, 101') und eine Kontaktschnittstelle (21, 21'), die in dem Körper (101, 101') angebracht ist, wobei die Kontaktschnittstelle (21, 21') äußere Verbindungsmittel (21a) für die Kommunikation mit dem Äußeren der Sicherheitsvorrichtung (100, 100') und innere Verbindungsmittel (21b, 21c) für die Kommunikation mit dem Inneren der Sicherheitsvorrichtung (100, 100') umfasst, wobei die Sicherheitsvorrichtung (100, 100') eine Chipkarte ist,
wobei der Körper (101, 101') das Format der Chipkarte (100, 100') definiert und mindestens ein erstes Substrat (300, 300') und ein zweites Substrat (400, 400') umfasst, die sich jeweils in parallelen Ebenen erstrecken und jeweils mindestens ein erstes elektronisches Bauteil (300a, 300a', 301, 301') und ein zweites elektronisches Bauteil (400a, 400a', 41, 42, 43, 44, 51, 52, 53, 54, 22') umfassen,
wobei die Sicherheitsvorrichtung (100, 100') **dadurch gekennzeichnet ist, dass** die Kontaktschnittstelle (21, 21') mit dem mindestens einen ersten elektronischen Bauteil (300a, 300a', 301, 30T) und dem einen zweiten elektronischen Bauteil (400a, 400a', 41, 42, 43, 44, 51, 52, 53, 54, 22') des mindestens einen ersten Substrats bzw. des eines zweiten Substrats (400, 400') mittels der inneren Verbindungsmittel (21b, 21c) elektrisch verbunden ist.

2. Sicherheitsvorrichtung nach Anspruch 1, **dadurch gekennzeichnet, dass** die Kontaktschnittstelle (21, 21') eine Außenfläche (21e), die bündig mit einer Außenfläche (101a) des Körpers (101, 101') ist, und eine Innenfläche (21i) umfasst, wobei die äußeren Verbindungsmittel (21a) der Kontaktschnittstelle (21, 2T) auf der Außenfläche (21e) angeordnet sind, und die inneren Verbindungsmittel (21b, 21c) der Kontaktschnittstelle (21, 21') auf der Innenfläche (21i) angeordnet sind.

3. Sicherheitsvorrichtung nach Anspruch 2, **dadurch gekennzeichnet, dass** sie ferner eine integrierte Schaltung (22) umfasst, die auf der Innenfläche (21i) der Kontaktschnittstelle (21) angebracht und mit mindestens einem Teil der äußeren (21a) und der inneren (21b, 21c) Verbindungsmittel der Kontaktschnittstelle (21) elektrisch verbunden ist.

4. Sicherheitsvorrichtung nach einem der Ansprüche 1 bis 3, **dadurch gekennzeichnet, dass** die inneren Verbindungsmittel (21b, 21c) mindestens einen ersten inneren Stecker (21b) und einen zweiten inneren Stecker (21c) umfassen, wobei der erste innere Stecker (21b) die Kontaktschnittstelle (21, 21') mit dem ersten elektronischen Bauteil (300a, 300a', 301, 301') des ersten Substrats (300, 300') verbindet, und der zweite innere Stecker (21c) die Kontaktschnittstelle (21, 21') mit dem zweiten elektronischen Bauteil des zweiten Substrats (400, 400') verbindet.

5. Sicherheitsvorrichtung nach einem der Ansprüche 1 bis 4, **dadurch gekennzeichnet, dass** sie einen anisotropen leitfähigen Film (500) umfasst, der zwischen der Innenfläche (21i) der Kontaktschnittstelle (21, 21') und dem ersten Substrat (300; 300') positioniert ist.

6. Sicherheitsvorrichtung nach einem der Ansprüche 1 bis 5, **dadurch gekennzeichnet, dass** mindestens das zweite Substrat (400, 400') einen Überlappungsbereich (402, 402') umfasst, der gegenüber mindestens einem Teil der inneren Verbindungsmittel (21c) der Kontaktschnittstelle (21, 21') angeordnet ist.

7. Sicherheitsvorrichtung nach Anspruch 6, **dadurch gekennzeichnet, dass** sie mindestens eine Lötkugel (401; 401') umfasst, die den Teil der inneren Verbindungsmittel (21c) der Kontaktschnittstelle (21; 21') mit dem zweiten elektronischen Bauteil des zweiten Substrats (400; 400') auf Höhe des Überlappungsbereichs (402; 402') verbindet.

8. Sicherheitsvorrichtung nach Anspruch 7, **dadurch gekennzeichnet, dass** sie einen anisotropen leitfähigen Film (501) umfasst, der zwischen dem Teil der inneren Verbindungsmittel (21c) der Kontaktschnittstelle (21; 21') und der mindestens einen Lötkugel (401; 401') positioniert ist.

9. Sicherheitsvorrichtung nach einem der Ansprüche 1 bis 8, **dadurch gekennzeichnet, dass** das erste Substrat (300, 300') mindestens einen Substrathohlraum umfasst, in den mindestens ein Teil des zweiten Substrats (400, 400') eingesetzt ist.

10. Verfahren zur Herstellung einer Sicherheitsvorrichtung, umfassend einen Körper (101; 101') und eine Kontaktschnittstelle (21; 21'), wobei die Sicherheitsvorrichtung (100, 100') eine Chipkarte ist, wobei der Körper (101; 101') das Format der Chipkarte (100, 100') definiert und mindestens ein erstes Substrat (300; 300') und ein zweites Substrat (400; 400') umfasst, die sich jeweils in parallelen Ebenen erstrecken und jeweils mindestens ein erstes elektronisches Bauteil (300a, 300a', 301, 301') und ein zweites elektronisches Bauteil (400a, 400a', 41, 42, 43, 44, 51, 52, 53, 54, 22') umfasst, und wobei die Kontaktschnittstelle (21; 21') äußere Verbindungsmittel (21a) für die Kommunikation mit dem Äußeren der Sicherheitsvorrichtung (100; 100') und innere Verbindungsmittel (21b, 21c) für die Kommunikation mit dem Inneren der Sicherheitsvorrichtung (100; 100') umfasst, wobei das Herstellungsverfahren umfasst:
- das Positionieren des ersten Substrats (300; 300') und des zweiten Substrats (400; 400') zwischen äußeren Schichten (102) des Körpers (101; 101'), und
- das Positionieren der Kontaktschnittstelle (21, 21') in dem Körper (101; 101'),
wobei das Herstellungsverfahren **dadurch gekennzeichnet ist, dass** es ferner das Einrichten einer elektrischen Verbindung der Kontaktschnittstelle (21; 21') mit dem mindestens einen ersten elektronischen Bauteil (300a, 300a', 301; 301') und einem zweiten elektronischen Bauteil (400a; 400a', 41, 42, 43, 44, 51, 52, 53, 54, 22') des mindestens einen ersten Substrats (300; 300') bzw. des einen zweiten Substrats (400; 400') mittels der internen Verbindungsmittel (21b, 21c) umfasst.

11. Herstellungsverfahren nach Anspruch 10, **dadurch gekennzeichnet, dass** es das Positionieren einer integrierten Schaltung (22) auf einer Innenfläche (21i) der Kontaktschnittstelle (21) und das elektrische Verbinden der integrierten Schaltung (22) mit mindestens einem Teil der äußeren (21a) und inneren (21b, 21c) Verbindungsmittel der Kontaktschnittstelle (21') umfasst.

12. Herstellungsverfahren nach einem der Ansprüche 10 oder 11, **dadurch gekennzeichnet, dass** es die Herstellung von mindestens einem Substrathohlraum in dem ersten Substrat (300; 300') umfasst, der dazu ausgelegt ist, mindestens einen Teil des zweiten Substrats (400; 400') aufzunehmen.

13. Herstellungsverfahren nach einem der Ansprüche 10 bis 12, **dadurch gekennzeichnet, dass** es die Herstellung mindestens eines Substrathohlraums in dem ersten Substrat (300, 300') umfasst, der dazu ausgelegt ist, mindestens ein elektronisches Bauteil (400a, 400a', 41, 42, 43, 44, 51, 52, 53, 54, 22') des zweiten Substrats (400, 400') aufzunehmen.

14. Herstellungsverfahren nach einem der Ansprüche 10 bis 13, **dadurch gekennzeichnet, dass** vor dem Positionieren des zweiten Substrats (400; 400') zwischen den äußeren Schichten (102) des Körpers (101, 101') das Herstellungsverfahren das Positionieren von mindestens einer Lötkugel (401; 401') auf dem zweiten Substrat (400; 400') umfasst.

15. Herstellungsverfahren nach Anspruch 14, **dadurch gekennzeichnet, dass** es ferner das Positionieren eines anisotropen leitfähigen Films (500, 501) zwischen der Kontaktschnittstelle (21; 21') und dem ersten Substrat (300; 300') und dem zweiten Substrat (400; 400') umfasst.

## Claims

1. A security device comprising a body (101,101') and a contact interface (21,21') mounted in said body (101,101'), said contact interface (21,21') comprising external connection means (21a) for communication with the outside of said security device (100,100') and internal connection means (21b, 21c) for communication with the inside of said security device (100,100'), said security device (100,100') being a chip card,
said body (101, 101') defining the format of said chip card (100,100') and comprising at least a first substrate (300,300') and a second substrate (400, 400') extending respectively in parallel planes, and comprising respectively at least a first electronic component (300a, 300a', 301, 301 ') and a second electronic component (400a, 400a', 41, 42, 43, 44, 51, 52, 53, 54, 22'),
said security device (100,100') being **characterized in that** said contact interface (21, 21') is electrically connected to said at least a first electronic component (300a, 300a', 301, 301') and a second electronic component (400a, 400a', 41, 42, 43, 44, 51, 52, 53, 54, 22') of said at least a first substrate and a second substrate (400, 400'), respectively, by means of said internal connection means (21b, 21c).

2. The security device in accordance with claim 1, **characterized in that** said contact interface (21,21') comprises an external face (21e) which is flush with an external face (101a) of said body (101,101') and an internal face (21i), said external connection means (21a) of said contact interface (21, 21') being arranged on said external face (21e), and said internal connection means (21b, 21c) of said contact interface (21,21') being arranged on said internal face (21i).

3. The security device in accordance with claim 2, **characterized in that** it further comprises an integrated circuit (22) mounted on said internal face (21i) of said contact interface (21) and electrically connected to at least part of said external connection means (21a) and internal connection means (21b, 21c) of said contact interface (21).

4. The security device in accordance with one of claims 1 to 3, **characterized in that** the internal connection means (21b, 21c) comprise at least a first internal connector (21b) and a second internal connector (21c), said first internal connector (21b) connecting said contact interface (21, 21') to said first electronic component (300a, 300a', 301, 301') of said first substrate (300, 300'), and said second internal connector (21c) connecting said contact interface (21, 21') to said second electronic component of said second substrate (400, 400').

5. The security device in accordance with one of claims 1 to 4, **characterized in that** it comprises an anisotropic conductive film (500) positioned between the internal face (21i) of said contact interface (21, 21') and said first substrate (300 ; 300').

6. The security device in accordance with one of claims 1 to 5, **characterized in that** at least said second substrate (400, 400') comprises a zone of overlap (402, 402') arranged facing at least part of the internal connection means (21c) of the contact interface (21, 21').

7. The security device in accordance with claim 6, **characterized in that** it comprises at least one solder ball (401; 401') connecting said part of the internal connection means (21c) of said contact interface (21; 21') to said second electronic component of said second substrate (400; 400') at said zone of overlap (402; 402').

8. The security device in accordance with claim 7, **characterized in that** it comprises an anisotropic conductive film (501) positioned between said part of the internal connection means (21c) of said contact interface (21 ; 21') and said at least one solder ball (401; 401').

9. The security device in accordance with one of claims 1 to 8, **characterized in that** said first substrate (300,300') comprises at least one substrate cavity wherein at least part of said second substrate (400,400') is inserted.

10. A method for producing a security device comprising a body (101; 101 ') and a contact interface (21; 21'), said security device (100,100') being a chip card, said body (101; 101 ') defining the format of said chip card (100,100') and comprising at least a first substrate (300; 300') and a second substrate (400; 400') extending respectively in parallel planes, and comprising respectively at least a first electronic component (300a, 300a', 301, 301 ') and a second electronic component (400a, 400a', 41, 42, 43, 44, 51, 52, 53, 54, 22'), and said contact interface (21; 21') comprising external connection means (21a) for communication with the outside of said security device (100; 100') and internal connection means (21b, 21c) for communication with the inside of said security device (100; 100'), said production method comprising:
- positioning said first substrate (300; 300') and said second substrate (400; 400') between external layers (102) of said body (101; 101'), and
- positioning said contact interface (21, 21') in said body (101; 101'),
said production method being **characterized in that** it further comprises implementing an electrical connection from said contact interface (21; 21') to said at least a first electronic component (300a, 300a', 301; 301') and a second electronic component (400a; 400a', 41,42, 43, 44, 51, 52, 53, 54, 22') of said at least a first substrate (300; 300') and a second substrate (400; 400'), respectively, by means of said internal connection means (21b, 21c).

11. The production method in accordance with claim 10, **characterized in that** it comprises positioning an integrated circuit (22) on an internal face (21i) of said contact interface (21) and electrically connecting said integrated circuit (22) to at least part of said external connection means (21a) and internal connection means (21b, 21c) of said contact interface (21').

12. The production method in accordance with one of claims 10 or 11, **characterized in that** it comprises producing at least one substrate cavity in said first substrate (300; 300'), which cavity is designed to receive at least part of said second substrate (400; 400').

13. The production method in accordance with one of claims 10 to 12, **characterized in that** it comprises producing at least one substrate cavity in said first substrate (300; 300'), which cavity is designed to receive at least one electronic component (400a, 400a', 41, 42, 43, 44, 51, 52, 53, 54, 22') of said second substrate (400; 400').

14. The production method in accordance with one of claims 10 to 13, **characterized in that**, before said positioning of said second substrate (400; 400') between the external layers (102) of said body (101, 101'), said production method comprises positioning at least one solder ball (401 ; 401') on said second substrate (400; 400').

15. The production method in accordance with claim 14, **characterized in that** it further comprises positioning an anisotropic conductive film (500,501) between said contact interface (21; 21') and said first substrate (300; 300') and second substrate (400; 400').
